Europäisches Patentamt

European Patent Office

Office européen des brevets

(19)

(11) Numéro de publication : **0 370 896 B1**

# (12) FASCICULE DE BREVET EUROPEEN

(45) Date de publication du fascicule du brevet :
**30.09.92 Bulletin 92/40**

(21) Numéro de dépôt : **89403210.1**

(22) Date de dépôt : **21.11.89**

(51) Int. Cl.⁵ : **H03K 17/08,** H03K 17/56,
H02M 7/537

---

## (54) Dispositif interrupteur de puissance, notamment pour convertisseur de fréquence.

---

(30) Priorité : **22.11.88 FR 8815162**

(43) Date de publication de la demande :
**30.05.90 Bulletin 90/22**

(45) Mention de la délivrance du brevet :
**30.09.92 Bulletin 92/40**

(84) Etats contractants désignés :
**AT BE CH DE ES GB IT LI NL SE**

(56) Documents cités :
**FR-A- 2 535 543
PATENT ABSTRACTS OF JAPAN, vol. 11, no.
127 (E-501)(2574), 21 avril 1987; & JP-A-61 270
914**

(73) Titulaire : **TELEMECANIQUE
43-45, Boulevard Franklin Roosevelt
F-92504 Rueil-Malmaison Cedex (FR)**

(72) Inventeur : **Gousset, Alain
31, avenue Charles Floquet
F-92500 Rueil Malmaison (FR)**
Inventeur : **Lafontaine, Jean
34, avenue Albine
F-78600 Maisons Laffitte (FR)**

(74) Mandataire : **Martin, Jean-Jacques et al
Cabinet REGIMBEAU 26, Avenue Kléber
F-75116 Paris (FR)**

EP 0 370 896 B1

**Description**

La présente invention a trait d'une façon générale à la commande de transistors de puissance, et elle concerne plus particulièrement, mais non exclusivement, la commande des transistors de puissance dans un pont, prévu par exemple dans le pont onduleur d'un convertisseur de fréquence pour la commande de vitesse de moteurs électriques ou dans un convertisseur continu-continu.

Un convertisseur de fréquence, qu'il soit monophasé ou triphasé, comprend classiquement un pont redresseur dont la sortie est appliquée à un onduleur. L'onduleur comprend, en un nombre égal ou nombre de phases du réseau, des bras de commutation constitués chacun d'un transistor de voie haute en série avec un transistor de voie basse; à chaque transistor est associée une diode de récupération. Un point intermédiaire entre les transistors est relié à un enroulement de phase du moteur.

Un problème bien connu dans ce type de convertisseur réside dans le fait que, lorsque les deux transistors d'un bras sont bloqués ou "ouverts" et qu'un courant circule dans l'une des diodes de récupération, par exemple dans la diode de voie haute, le chemin collecteur-émetteur du transistor de voie haute est assujetti à une tension négative égale à la tension de seuil de la diode. En conséquence, la jonction base-collecteur du transistor est polarisée en direct et il en résulte une accumulation de charges qui doivent être évacuées d'une manière ou d'une autre pour ne pas compromettre la bonne marche de l'onduleur. Le même problème existe dans les transistors de voie basse lorsque la diode de voie basse conduit.

Un tel problème est facilement résolu avec les transistors de puissance de type MOS; en effet, les charges sont des porteurs majoritaires et il suffit de décharger la capacité grille-source dans laquelle les charges se sont accumulées; c'est pourquoi ce type de dispositif est couramment utilisé pour la commutation dans des convertisseurs de fréquence de faible puissance.

Cependant, lorsque l'on souhaite travailler à des puissances plus élevées, le coût élevé des transistors MOS devient un facteur économique important, et l'on préfère utiliser des transistors bipolaires, moins coûteux. Mais le problème mentionné plus haut prend alors toute son importance: il est dans ce cas nécessaire d'assurer une polarisation négative de la base du transistor, afin d'évacuer les charges, constituées de porteurs cette fois-ci minoritaires, qui tendent à s'accumuler dans la jonction base-collecteur (JP-A-61270914).

Toute solution au problème doit tenir compte du fait que les émetteurs des transistors de voie basse sont référencés à un potentiel fixe, tandis que les émetteurs des transistors de voie haute sont référencés à un potentiel flottant.

Les solutions connues visant à appliquer la polarisation négative souhaitée sont désavantageuses du point de vie du coût et de l'encombrement; notamment, l'usage d'un transformateur introduit des capacités parasites qui sont préjudiciables au bon fonctionnement du convertisseur, notamment à des fréquences de commutation élevées.

La présente invention vise à éviter l'usage d'un transformateur et à pallier les inconvénients de la technique antérieure en proposant un dispositif interrupteur dans lequel sont appliquées à l'électrode de commande d'un transistor de puissance bipolaire ou d'un étage de puissance incluant un tel transistor, les polarisations positive et négative requises, et ceci au moyen d'un circuit électronique simple, peu encombrant, économique, intégrable et présentant de très faibles capacités parasites.

A cet effet, la présente invention concerne un dispositif interrupteur de puissance comprenant un étage de puissance à transistor bipolaire et un circuit de commande de cet étage; le circuit de commande comporte des premiers moyens de polarisation pour appliquer audit égale, pendant des premiers intervalles de temps, des impulsions de polarisation directe destinées à le rendre conducteur, ainsi que des seconds moyens de polarisation pour appliquer audit étage, pendant des seconds intervalles de temps, des impulsions de polarisation inverse destinées à éviter que des charges ne s'accumulent dans le transistor pendant qu'il est exposé à une tension inverse. Les premiers moyens de polarisation comprennent un premier condensateur et un premier circuit de commutation pour sélectivement charger le premier condensateur à l'aide d'une source de tension continue en dehors des premiers intervalles de temps et le décharger dans une entrée de commande dudit étage; les seconds moyens de polarisation comprennent un second condensateur et un second circuit de commutation pour sélectivement charger le second condensateur à l'aide de la source de tension en dehors des seconds intervalles de temps et le décharger dans l'entrée de commande.

Ainsi l'invention permet, en utilisant un simple condensateur chargé par la source de tension même qui est utilisée pour la polarisation directe et en le déchargeant à des instants appropriés, d'appliquer au transistor la polarisation inverse requise pour sa protection pendant tous les intervalles de temps au cours desquels sa tension collecteur-émetteur devient négative.

Des aspects préférés du dispositif de interrupteur de puissance de l'invention sont les suivants :

. le premier condensateur comprend une première borne pouvant être reliée sélectivement à la source de tension et à l'entrée de commande de l'étage de puissance et une seconde borne reliée à une borne de sortie de courant de l'étage de puissance; le premier circuit de commutation comprend un premier interrupteur pour isoler la première borne du premier condensateur de l'entrée de commande pendant la charge du condensateur et un premier moyen de blocage pour isoler la source de tension de la première borne du condensateur au moins pendant les premiers intervalles de temps.

. le second condensateur comprend une première borne pouvant être reliée sélectivement à la source de tension et à la borne de sortie de courant de l'étage de puissance et une seconde borne pouvant être reliée sélectivement à la borne de sortie de courant et à l'entrée de commande de l'étage de puissance; le second circuit de commutation comprend des deuxième et troisième interrupteurs pour respectivement isoler la première borne du second condensateur de la sortie de courant de l'étage de puissance et isoler la seconde borne du second condensateur de l'entrée de commande dudit étage pendant la charge dudit condensateur et des deuxième et troisième moyens de blocage pour respectivement isoler la première borne du second condensateur de la source de tension et isoler la seconde borne du second condensateur de la sortie de courant pendant les seconds intervalles de temps.

. les premier et troisième interrupteurs sont constitués par un transistor, de préférence Darlington, dont une entrée de commande est contrôlée par un signal de commande, dont le collecteur est relié d'une part à la première borne du premier condensateur par une résistance et d'autre part à l'entrée de commande de l'étage de puissance et dont l'émetteur est relié à la seconde borne du second condensateur.

. les premier et deuxième moyens de blocage comprennent en commun une première diode montée entre la source de tension et les premières bornes respectives des premier et second condensateurs.

. les premier et deuxième moyens de blocage comprennent en outre respectivement des seconde et troisième diodes montées entre la première diode et les premières bornes des premier et second condensateurs.

. dans le cas où l'étage de puissance est un étage de voie haute d'un onduleur monté en série avec un étage de puissance de voie basse entre un conducteur de voie haute et un conducteur de voie basse, la source de tension est référencée sur le conducteur de voie basse et les premier et deuxième moyens de blocage sont commandés par des changements de signe de la différence de potentiel entre le point d'entrée de la source de tension et la borne de sortie de courant de l'étage de voie haute.

. le deuxième interrupteur comprend un transistor dont une entrée de commande est associée à un quatrième interrupteur lui-même commandé par les changements de potentiel, dont une borne d'entrée de courant est reliée à la première borne du second condensateur et dont une borne de sortie de courant est reliée à la borne de sortie de courant de l'étage de puissance.

. le quatrième interrupteur comprend un transistor dont l'entrée de commande est reliée à la sortie d'un pont diviseur monté entre les bornes du premier condensateur.

. le troisième moyen de blocage comprend un diode montée entre la seconde borne du second condensateur et la sortie de courant de l'étage de puissance.

. le signal de commande de polarisation directe commande les premier et troisième interrupteurs par l'intermédiaire d'un optocoupleur.

. l'étage de puissance peut comprendre au choix un montage en cascade d'un transistor MOS et d'un transistor bipolaire, un montage Darlington de deux transistors bipolaires, un transistor bipolaire unique ou encore un transistor bipolaire à grille isolée.

. le deuxième interrupteur comprend un transistor MOS dont la capacité grille-source détermine avec une résistance en série avec sa grille une constante de temps fixant la durée pendant laquelle ledit transistor MOS est conducteur.

D'autres aspects, buts et avantages de la présente invention apparaîtront mieux à la lecture de la description suivante d'une forme de réalisation préférée de celle-ci, donnée à titre d'exemple et faite en référence aux dessins annexés, sur lesquels :

– la figure 1 est le schéma de principe d'un convertisseur de fréquence auquel la présente invention se rapporte;

– la figure 2 est un schéma d'une partie du circuit de la figure 1 destiné à illustré le problème résolu par la présente invention; et

– la figure 3 est le schéma détaillé d'un circuit de commande conforme à la présente invention.

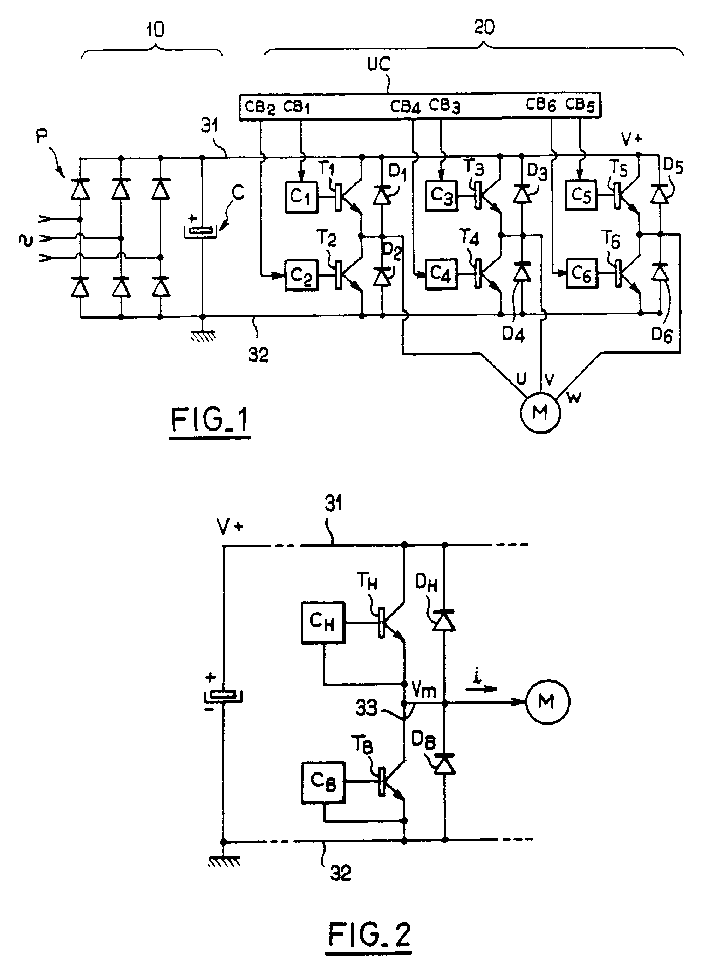

En référence tout d'abord à la figure 1, un circuit convertisseur statique de fréquence, notamment pour la commande de vitesse de moteurs asynchrones, est relié à un réseau de tension alternative monophasé ou polyphasé, dans le présent exemple triphasé.

Le convertisseur est du type à onde de tension et comporte un circuit redresseur triphasé 10 et un onduleur 20. Le circuit redresseur 10 est constitué par un pont redresseur P comportant six diodes connectées aux phases du réseau et un condensateur de filtrage C de manière à délivrer à l'onduleur une tension continue, par l'intermédiaire d'un conducteur de voie haute 31 et un conducteur de voie basse 32.

L'onduleur 20 est relié, côté entrée, aux deux conducteurs 31 et 32, côté sortie, aux trois conducteurs de phase U, V et W d'un moteur asynchrone M. Le moteur M pourrait également être un moteur asynchrone synchronisé.

L'onduleur 20 comprend six interrupteurs statiques commandés, montés en pont de Graetz et constitués conventionnellement de transistors $T_1$ à $T_6$ tels que des transistors bipolaires. En parallèle avec les bornes émetteur-collecteur des transistors sont disposées six diodes de récupération ou de "roue libre" $D_1$ à $D_6$.

Chaque bras du pont comprend d'une paire de transistors : un transistor dit de voie haute, respectivement $T_1$, $T_3$, et $T_5$, et un transistor dit de voie basse, respectivement $T_2$, $T_4$ et $T_6$. Le point milieu de chaque paire de transistors est relié à une impédance statorique du moteur M, de façon non illustrée.

Les bases des transistors $T_1$ à $T_6$ sont commandées respectivement par six dispositifs de commande associés $C_1$ à $C_6$, du type agencé pour délivrer auxdites bases un signal en impulsions à largeur modulée (PWM) pour la commande de la vitesse de rotation du moteur, de façon bien connue en soi. Enfin une unité de commande UC, par exemple à microprocesseur, envoie aux dispositifs de commande $C_1$ à $C_6$ les signaux de commande appropriés, respectivement $CB_1$ à $CB_6$.

On a représenté sur la figure 2 un étage de l'onduleur de la figure 1, destiné à illustrer le problème résolu conformément à la présente invention. Sur cette figure, le transistor et la diode de voie haute sont désignés par $T_H$ et $D_H$, tandis que le transistor et la diode de voie basse sont désignés par les références $T_B$ et $T_B$. De même, les commandes de voie haute et de voie basse sont désignées par $C_H$ et $C_B$, respectivement. La tension continue fournie par le redresseur est symbolisée par un générateur délivrant la tension V.

Si l'on prend comme référence des tensions le potentiel (0 V) du conducteur de voie basse 32, alors la tension Vm présente au point milieu de la paire de transistors (ligne 33) est soit sensiblement nulle (dans le cas où $T_B$ ou $D_B$ conduit), soit sensiblement égale à V+ (dans le cas où $T_H$ ou $D_H$ conduit).

Cela signifie que la tension de référence du circuit de commande $C_H$, prise sur l'émetteur de $T_H$, est flottante, tandis que la tension de référence du circuit de commande $C_B$, prise sur l'émetteur de $T_B$, est constante. En pratique, cela signifie qu'il faut prévoir une alimentation flottante individuelle pour chacun des circuits de commande $C_H$, tandis que les circuits de commande $C_B$ peuvent se contenter d'une alimentation commune référencée sur le conducteur de voie basse 32.

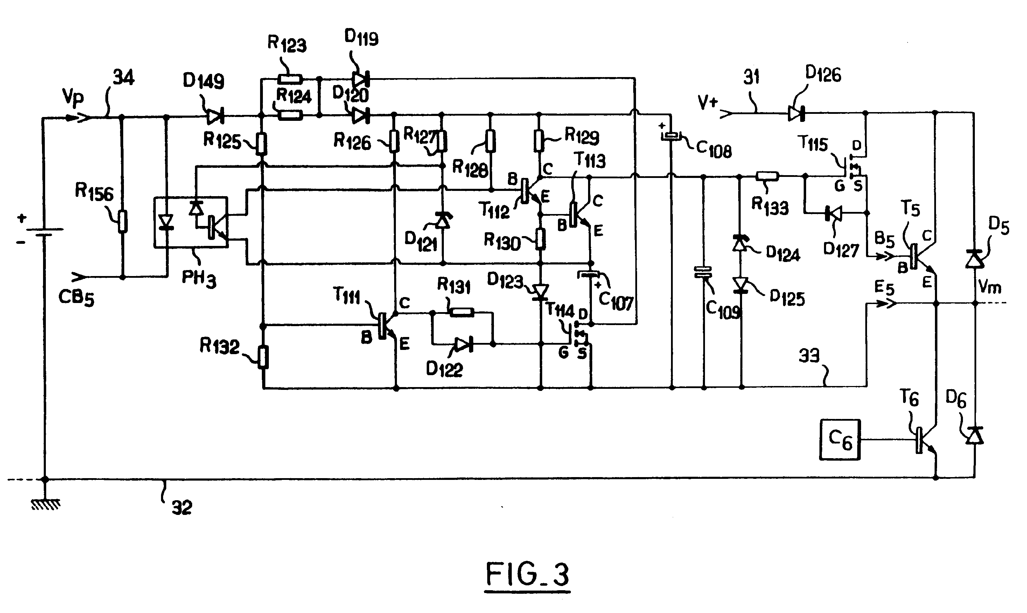

On va maintenant décrire en détail un circuit de commande conforme à la présente invention, en référence à la figure 3.

Le circuit décrit est le circuit $C_5$ associé au transistor de puissance $T_5$ de voie haute de l'onduleur. Il est appliqué à ce circuit une tension continue positive Vp, par exemple de l'ordre de 15 volts; cette tension est appliquée entre une ligne 34 d'alimentation et le conducteur de voie basse 32 du convertisseur, supposé être la masse. Le circuit $C_5$ reçoit sur une entrée $CB_5$ un signal de commande pour le transistor $T_5$.

L'entrée $CB_5$ est reliée à Vp par l'intermédiaire de la diode électro-luminescente d'un opto-coupleur $PH_3$ en parallèle avec une résistance $R_{156}$. La ligne 34 est reliée par l'intermédiaire d'une diode $D_{149}$, d'une résistance $R_{124}$ et d'une autre diode $D_{120}$, en série, à la borne positive d'un condensateur de polarisation positive $C_{108}$ dont la borne négative est reliée au point milieu 33 des transistors $T_5$ et $T_6$, auquel règne la tension Vm.

La ligne 34 est en outre reliée, par la diode $D_{149}$, une résistance $R_{123}$ et une autre diode $D_{119}$, en série, au drain D d'un transistor MOS $T_{114}$ et à la borne positive d'un condensateur de polarisation négative $C_{107}$, dont la borne négative est relié entre autres à l'émetteur du photo-transistor du coupleur $PH_3$.

Par ailleurs, deux résistances $R_{125}$ et $R_{132}$ montées en série entre la cathode de la diode $D_{149}$ et la ligne 33 de tension de référence $V_m$ forment un pont diviseur pour la polarisation de la base d'un transistor bipolaire NPN $T_{111}$ dont l'émetteur est relié à la ligne 33 et dont le collecteur est relié d'une part à la cathode de $D_{120}$ via une résistance de collecteur $R_{126}$ et d'autre part à la grille du transistor MOS $T_{114}$ via le montage en parallèle d'une résistance $R_{131}$ et d'une diode $D_{122}$.

La base du photo-transistor de l'optocoupleur $PH_3$ est reliée via une diode à une résistance $R_{127}$ reliée à la cathode de $D_{120}$ ainsi qu'à la cathode d'une diode Zéner de protection $D_{121}$. En outre, Le collecteur du photo-transistor de $PH_3$ est relié à la base d'un transistor $T_{112}$ formant avec un transistor $T_{113}$ une paire Darlington, une résistance $R_{128}$ reliant la base de $T_{112}$ à la cathode de $D_{120}$; une résistance $R_{129}$ relie les collecteurs de $T_{112}$ et $T_{113}$ à la cathode de $D_{120}$.

L'émetteur du photo-transistor est relié à l'anode de la diode Zéner $D_{121}$, à l'émetteur de $T_{113}$ ainsi qu'à la liaison émetteur-base de la paire Darlington $T_{112}$-$T_{113}$ par l'intermédiaire d'une résistance $R_{130}$. Comme on l'a indiqué plus haut, la borne négative du condensateur $C_{107}$ est également reliée à un point commun à l'émetteur du photo-transistor, et à l'émetteur de $T_{113}$.

Une diode $D_{123}$ est montée entre ce même point et la ligne 33, à laquelle est également reliée la source de $T_{114}$.

Les collecteurs de la paire Darlington $T_{112}$-$T_{113}$ sont reliés à la ligne 33 d'une part par un condensateur $C_{109}$ et d'autre part par le montage série et tête-bêche d'un diode Zéner $D_{124}$ et d'une diode $D_{125}$. Ils sont en outre reliés via une résistance $R_{133}$ à la grille d'un transistor MOS $T_{115}$. Le transistor $T_{115}$ pilote le transistor $T_5$ et constitue avec celui-ci un étage de puissance MOS-bipolaire.

Plus précisément, la source de $T_{115}$ est reliée à la base de $T_5$ par le point de connexion $B_5$, et est reliée à la grille de $T_{115}$ par une diode $D_{127}$. L'émetteur de $T_5$ est relié à la ligne de référence 33 par le point de connexion $E_5$ et à l'anode de la diode de récupération associée $D_5$. Ce point, qui est le point milieu des transistors de commutation $T_5$-$T_6$ associés à la phase W du moteur, est également relié au collecteur du transistor $T_6$ et à la cathode de la diode de récupération $D_4$ et, de façon non illustrée, à la phase associée du moteur à commander. La tension V+ présente sur le conducteur de voie haute 31 est reliée au drain du transistor MOS $T_{115}$, au collecteur de $T_5$ et à la cathode de la diode $D_5$.

Le condensateur $C_{108}$ constitue une source de tension qui est chargée pendant que le transistor est bloqué et qui est ensuite utilisée pour polariser positivement ce transistor et le rendre conducteur.

En outre, la partie de circuit constituée par $PH_3$, $T_{112}$-$T_{113}$, $R_{128}$, $R_{130}$ et $D_{123}$ constitue le circuit de commande proprement-dit de l'étage de puissance MOS-bipolaire $T_{115}$-$T_5$, pour alternativement rendre bloqué et conducteur le transistor $T_5$ en coopération avec le condensateur $C_{108}$.

On va décrire ci-dessous le fonctionnement du circuit tel que décrit ci-dessus.

La commande de transistor $T_5$ s'effectue par application sur la borne $CB_5$ d'un signal de commande; pour déterminer la fermeture de $T_5$, ce signal prend un niveau inférieur à Vp, par exemple 0 volt; pour commander l'ouverture de $T_5$, le niveau du signal est Vp.

On rappelle que la commande des transistors $T_5$ et $T_6$ s'effectue selon un cycle dit de commande complémentaire, qui est le suivant :
– pendant le temps $t_1$, $T_6$ est conducteur tandis que $T_5$ est bloqué;
– pendant un court intervalle de temps de sécurité, noté $t_2$, par exemple de l'ordre de 15 µs, $T_5$ et $T_6$ sont bloqués tous les deux; on évite ainsi tout risque de court-circuit des conducteurs de voie haute et de voie basse 31 et 32;
– pendant le temps $t_3$ qui suit, $T_5$ est conducteur tandis que $T_6$ reste bloqué; et
– pendant un second intervalle de temps de sécurité $t_4$, jouant le même rôle que $t_2$, $T_5$ et $T_6$ sont bloqués.

Si l'on se place pendant l'intervalle $t_1$, $t_6$ étant conducteur, le point milieu M entre $T_5$ et $T_6$ et le conducteur 33 sont au 0 volt. Par ailleurs, le signal $CB_5$ étant au niveau bas, le photo-transistor de $PH_3$ est bloqué. Il en résulte que la base de $T_{112}$ est polarisée positivement via $R_{128}$, et le Darlington $T_{112}$-$T_{113}$ est donc passant.

La différence de potentiel entre les lignes 34 et 33 étant à cet instant positive, et pratiquement égale à Vp, le condensateur de polarisation positive $C_{108}$ est

rechargé via $D_{149}$, $D_{124}$ et $D_{120}$. Le courant passant dans le conducteur 34 traverse $R_{129}$, $T_{113}$ et $D_{123}$, de sorte que $T_{115}$ et $T_5$ restent bloqués. A cet égard, on peut noter que, dans cette situation, une tension positive (sensiblement égale aux tensions de seuil cumulées de $T_{113}$ et $D_{123}$) est tout de même appliquée à la grille G de $T_{115}$, mais cette tension est inférieure à la tension de seuil de $T_{115}$ et n'en provoque pas la conduction. Ainsi $T_{115}$ joue ici avantageusement le rôle d'un dispositif à seuil, permettant de s'affranchir des chutes de tension naissant dans les divers composants du dispositif.

En outre, toujours en raison du fait que Vp-Vm est positif, une tension sensiblement égale à Vp divisée par le pont diviseur $R_{125}$, $R_{132}$ est appliquée à la base de $T_{111}$, qui est donc conducteur. La branche $R_{126}$, $T_{121}$ étant passante, $T_{114}$ est bloqué. En conséquence, le condensateur de polarisation négative $C_{107}$ se charge via $D_{149}$, $R_{123}$, $D_{119}$ et $D_{123}$. Il est à noter que, pendant cette charge, la diode $D_{123}$ ne joue aucun rôle particulier.

A la transition entre les intervalles $t_1$ et $t_2$, le transistor $T_6$ s'ouvre.

La tension Vm remonte alors brusquement. Dès que Vm dépasse Vp, la diode $D_{149}$ se bloque, tout comme les diodes $D_{119}$ et $D_{120}$. En conséquence, aucun courant ne peut plus circuler vers la base de $T_{111}$, qui se bloque. La grille de $T_{114}$ est alors sollicitée via $R_{126}$ et $D_{122}$, par la tension présente aux bornes de $C_{108}$; il devient passant, ceci n'occasionnant qu'une très faible décharge de $C_{108}$. La diode $D_{122}$ permet dans cette situation de ne pas limiter excessivement le courant circulant vers la grille de $T_{114}$, si bien que la capacité grille-source de $T_{114}$ se charge aussi vite que possible et que ce dernier transistor est rendu passant avec un très faible temps de réaction, nécessaire comme on va le voir ci-dessous pour une bonne protection de l'étage de puissance.

La base du transistor $T_{111}$ peut être commandée par une logique L.

Pendant l'intervalle $t_2$, puisque le signal $CB_5$ reste à son niveau bas, le Darlington $T_{112}$-$T_{113}$ est encore passant, comme on l'a indiqué plus haut. Il est ainsi créé un circuit en boucle constitué par la borne positive de $C_{107}$, $T_{114}$, le trajet émetteur-base de $T_5$, $D_{127}$, $R_{133}$, $T_{113}$, et la borne négative de $C_{107}$; ce circuit est établi aussi longtemps que $T_{113}$ et $T_{114}$ sont conducteurs. On applique ainsi pendant toute la durée de l'intervalle $t_2$ une polarisation base-émetteur négative au transistor $T_5$, la tension de polarisation étant issue du condensateur chargé $C_{107}$. La diode $D_{122}$ est polarisée en inverge pendant $t_2$.

En résumé, le condensateur $C_{107}$ se charge pendant l'intervalle $t_1$, par la tension positive Vp-Vm puis, par des moyens de commutation appropriés constitués notamment par $T_{113}$ et $T_{114}$, le condensateur $C_{107}$ se décharge avec son électrode négative reliée à la base et son électrode positive reliée à l'émetteur de

$T_5$.

Cette polarisation négative permet d'éviter l'accumulation de charges dans le transistor $T_5$ lorsque le courant moteur s'écoule à travers la diode de récupération $D_5$ (ce qui est normalement le cas quand le transistor $T_6$ s'ouvre).

Si l'on souhaite réduire le courant de polarisation négative de $T_5$, on peut mettre en série avec la diode source-grille $D_{127}$ de $T_{115}$ une résistance (non représentée), venant s'ajouter à la résistance $R_{133}$ et déterminant avec elle la valeur de ce courant.

A la transition entre les intervalles de temps $t_2$ et $t_3$, le signal de commande $CB_5$ passe au niveau haut pour fermer le transistor $T_5$. En conséquence, la diode électroluminescente de $PH_3$ s'illumine et rend le photo-transistor conducteur. La tension base-émetteur de $T_{112}$ est ramenée au voisinage de zéro, si bien que le Darlington $T_{112}$-$T_{113}$ se bloque. Le circuit de polarisation négative décrit plus haut est immédiatement interrompu.

En outre, $T_{113}$ étant bloqué, le courant disponible à partir de la borne positive du condensateur de polarisation positive $C_{108}$ peut alors circuler, via $R_{129}$ et $R_{133}$, en direction de la grille de $T_{115}$. L'étage MOS-bipolaire $T_{115}$, $T_5$ est dès lors polarisé positivement et $T_5$ conduit. On peut noter que le condensateur $C_{108}$, même doté de dimensions modestes, est apte à assurer cette polarisation pendant tout l'intervalle $t_3$ étant donné que la consommation en courant de la grille de $T_{115}$, de type MOS, est très faible.

On peut noter ici que, pendant l'intervalle $t_3$, $C_{107}$ n'est pas rechargé par la différence de potentiel positive entre Vm et Vp, étant donné que le transistor $T_{114}$ empêche que du courant ne circule vers sa borne positive. Dans le même temps, la diode $D_{123}$ empêche ce condensateur de se décharger.

Lors de la transition entre $t_3$ et $t_4$, le signal $CB_5$ revient au niveau bas, si bien que le Darlington $T_{112}$-$T_{113}$ devient à nouveau conducteur. Ceci a deux conséquences majeures. D'une part, $C_{108}$ peut se décharger à travers $T_{113}$ et $D_{123}$, si bien que la polarisation positive de $T_{115}$ s'effondre. D'autre part, le circuit de polarisation négative créé pendant l'intervalle $t_2$, est établi et sollicite à nouveau $T_5$.

Dans ce cas, il est vrai qu'en principe le courant de récupération va circuler dans $D_6$ et qu'aucun courant n'est susceptible de circuler dans la diode $D_5$. Cette nouvelle polarisation inverse apparaît donc superflue. Mais elle n'est pas gênante et cette solution présente l'avantage de ne pas compliquer le circuit par des moyens de commutation additionnels. Il est bien entendu que l'homme de l'art pourra concevoir de tels moyens de commutation additionnels pour éviter cette polarisation.

Lorsque le cycle se renouvelle, $C_{107}$ et $C_{108}$ se rechargent à nouveau pour pouvoir appliquer à $T_5$ les polarisations requises lors des intervalles ultérieurs $t_2$, $t_3$ et $t_4$.

Selon une variante de la présente inventionn, on prévoit que $C_{108}$ participe à la recharge de $C_{107}$. Plus précisément, on peut prévoir entre les cathodes respectives de $D_{120}$ et $D_{119}$ un résistance en série avec une diode (non illustrées) qui permettront à $C_{108}$ de se décharger au moins partiellement dans $C_{107}$ pendant la phase de recharge de ce dernier.

On peut noter que le choix des valeurs ohmiques de $R_{126}$ et $R_{131}$ répond à des considérations particulières. Plus précisément, pendant la décharge de $C_{107}$ correspondant à la polarisation négative de $T_5$, il est particulièrement important de ne pas bloquer $T_{114}$ pour ne pas interrompre le circuit de polarisation. Dans le cas présent, la résistance $R_{131}$ et la capacité grille-source de $T_{114}$ jouent le rôle d'une constante de temps qui permet de ralentir la chûte de tension sur la grille de $T_{114}$ une fois que, par blocage des diodes $D_{149}$, $D_{119}$ et $D_{120}$, la tension Vp n'est plus disponible. En outre, la valeur de $R_{126}$, par exemple de l'ordre du dixième de celle de $R_{131}$, doit être choisie assez faible pour que le transistor $T_{114}$ soit rendu passant aussi vite que possible, comme indiqué plus haut.

En pratique, on choisit la valeur de $R_{131}$ en fonction des caractéristiques du type de transistor MOS utilisé pour $T_{114}$, de telle sorte que la constante de temps précitée soit supérieure à l'intervalle de temps précité entre l'ouverture de $T_6$ et la fermeture de $T_5$.

La diode Zéner $D_{121}$ a pour objet de protéger l'optocoupleur $PH_3$, notamment pour écrêter toute pointe de tension apparaissant entre l'émetteur et le collecteur du photo-transistor lors du brusque changement de valeur de Vm et des diverses commutations. En outre, c'est à cause de la présence de $D_{121}$ qu'il est nécessaire de donner à $R_{127}$ une valeur relativement élevée, afin d'éviter que cette résistance ne provoque un courant de charge important de $C_{107}$.

Au démarrage du convertisseur de fréquence équipé de dispositifs de commande de la présente invention, il est nécessaire de charger les condensateurs de polarisation positive et négative. Ceci est avantageusement effectué en commençant par rendre conducteurs tous les transistors de voie basse, ce qui correspond dans chacune des phases à l'intervalle de temps $t_1$ correspondant à la recharge de ces condensateurs.

La présente invention s'applique non seulement à la commande d'étages de puissance MOS-bipolaire, mais également à des transistors bipolaires à grille isolée (IGBT), ou à des transistors bipolaires, seuls ou montés en Darlington. Dans ce cas, il est nécessaire de reconstituer d'un manière ou d'une autre la fonction "dispositif à seuil" offerte par le MOS d'entrée $T_{115}$. Une possibilité consiste à attaquer la base d'un tel transistor bipolaire, ou du premier transistor de la paire, avec une ou plusieurs diodes en série.

Bien que le dispositif selon l'invention soit utilisé très avantageusement pour la commande de transistors référencés à un potentiel flottant, il est bien entendu qu'il peut être adopté pour des transistors référencés à un potentiel fixe.

L'invention s'applique non seulement aux ponts onduleurs des convertisseurs de fréquence, mais également aux ponts des convertisseurs continu-continu et plus généralement à chaque fois qu'un transistor de puissance commandé sous une fréquence pouvant atteindre plusieurs dizaines de kHz risque d'être assujetti, à l'état ouvert, à une tension collecteur-émetteur négative.

Par ailleurs, la protection du transistor T115 et/ou du transistor T5 peut être assurée de différentes manières. Ainsi, la résistance R133 peut être disposée en amont de la connexion du montage série D124, D125 avec la grille de T115 de la diode D125 peut être remplacée par une diode Zener.

**Revendications**

1. Dispositif interrupteur de puissance ($T_{115}$, $T_5$) comprenant au moins un étage de puissance à transistor bipolaire ($T_5$) et un circuit de commande de cet étage, le circuit de commande comportant des premiers moyens de polarisation pour appliquer audit étage, pendant des premiers intervalles de temps ($t_3$), une polarisation directe, ainsi que des seconds moyens de polarisation pour appliquer audit étage, pendant des seconds intervalles de temps ($t_2$, $t_4$), une polarisation inverse destinée à éviter que des charges ne s'accumulent dans le transistor pendant qu'il est exposé à une tension inverse, caractérisé en ce que :
   – les premiers moyens de polarisation comprennent un premier condensateur ($C_{108}$) et un premier circuit de commutation ($D_{120}$, $T_{113}$) pour sélectivement charger le premier condensateur à l'aide d'une source de tension continue ($Vp$) en dehors des premiers intervalles de temps et décharger le premier condensateur dans une entrée de commande ($T_{115}$-G) dudit étage, et
   – les seconds moyens de polarisation comprennent un second condensateur ($C_{107}$) et un second circuit de commutation ($D_{119}$, $D_{123}$, $T_{113}$, $T_{114}$) pour sélectivement charger le second condensateur à l'aide de la source de tension en dehors des seconds intervalles de temps et décharger le second condensateur dans l'entrée de commande.

2. Dispositif selon la revendication 1, caractérisé en ce que :
   – le premier condensateur ($C_{108}$) comprend une première borne pouvant être reliée sélectivement à la source de tension ($Vp$) et à l'entrée de commande ($T_{115}$-G) de l'étage de puissance et une seconde borne reliée à une borne de sortie de courant ($E_5$) de l'étage de puissance, et
   – le premier circuit de commutation comprend un premier interrupteur ($T_{113}$) pour isoler la première borne du premier condensateur de l'entrée de commande pendant la charge du condensateur et un premier moyen de blocage ($D_{120}$) pour isoler la source de tension ($Vp$) de la première borne du condensateur au moins pendant les premiers intervalles de temps ($t_3$).

3. Dispositif selon la revendication 2, caractérisé en ce que:
   – le second condensateur ($C_{107}$) comprend une première borne pouvant être reliée sélectivement à la source de tension ($Vp$) et à la borne de sortie de courant ($E_5$) de l'étage de puissance et une seconde borne pouvant être reliée sélectivement à la borne de sortie de courant ($E_5$) et à l'entrée de commande ($T_{115}$-G) de l'étage de puissance,
   – le second circuit de commutation comprend un deuxième ($T_{114}$) et un troisième ($T_{113}$) interrupteurs pour respectivement isoler la première borne du second condensateur de la sortie de courant de l'étage de puissance et isoler la seconde borne du second condensateur de l'entrée de commande dudit étage pendant la charge du second condensateur et des deuxième ($D_{119}$) et troisième ($D_{123}$) moyens de blocage pour respectivement isoler la première borne du second condensateur de la source de tension et isoler la seconde borne du second condensateur de la sortie de courant pendant les seconds intervalles de temps.

4. Dispositif selon la revendication 3, caractérisé en ce que les premier et troisième interrupteurs sont constitués par un même interrupteur à transistors ($T_{112}$, $T_{113}$) dont une entrée de commande est contrôlée par un signal de commande ($CB_5$), dont le collecteur est relié d'une part à la première borne du premier condensateur ($C_{108}$) par une résistance ($R_{129}$) et d'autre part à l'entrée de commande ($T_{115}$-G) de l'étage de puissance et dont l'émetteur est relié à la seconde borne du second condensateur ($C_{107}$).

5. Dispositif selon la revendication 4, caractérisé en ce que l'interrupteur à transistors comprend une paire de transistors Darlington ($T_{112}$, $T_{113}$).

6. Dispositif selon l'une des revendications 3 à 5, caractérisé en ce que les premier et deuxième moyens de blocage comprennent en commun une première diode ($D_{149}$) montée entre la source de tension (Vp) et les premières bornes respectives des premier et second condensateurs (C$_{108}$, C$_{107}$).

7. Dispositif selon la revendication 6, caractérisé en ce que les premier et deuxième moyens de blocage comprennent en outre respectivement des seconde et troisième diodes (D$_{120}$, D$_{119}$) montées entre la première diode (D$_{149}$) et les premières bornes des premier et second condensateurs (C$_{108}$, C$_{107}$).

8. Dispositif selon l'une des revendications 6 et 7, dans lequel l'étage de puissance (T$_{115}$, T$_5$) est un étage de voie haute d'un onduleur (20), monté en série avec un étage de voie basse (T$_6$) entre un conducteur de voie haute (31) et un conducteur de voie basse (32), caractérisé en ce que la source de tension (Vp) est référencée sur le conducteur de voie basse (32) et en ce que les premier et deuxième moyens de blocage (D$_{149}$, D$_{120}$, D$_{119}$) sont commandés par des changements de signe de la différence de potentiel (Vp - Vm) entre le point d'entrée (Vp) de la source de tension et la borne de sortie de courant (E$_5$) de l'étage de voie haute.

9. Dispositif selon la revendication 8, caractérisé en ce que le deuxième interrupteur comprend un transistor (T$_{114}$) dont une entrée de commande (G) est associée à un quatrième interrupteur (T$_{111}$) lui-même commandé par les changements de potentiel, dont une borne d'entrée de courant (T$_{114}$-D) est reliée à la première borne du second condensateur (C$_{107}$) et dont une borne de sortie de courant (T$_{114}$-S) est reliée à la borne de sortie de courant (E$_5$) de l'étage de puissance.

10. Dispositif selon la revendication 9, caractérisé en ce que le quatrième interrupteur comprend un transistor (T$_{111}$) dont l'entrée de commande est reliée à la sortie d'un pont diviseur (R$_{125}$, R$_{132}$) monté entre les bornes du premier condensateur (C$_{108}$).

11. Dispositif selon l'une des revendications 8 à 10, caractérisé en ce que le troisième moyen de blocage comprend une diode (D$_{123}$) montée entre la seconde borne du second condensateur (C$_{107}$) et la sortie de courant (E$_5$) de l'étage de puissance.

12. Dispositif selon la revendication 4, caractérisé en ce que le signal de commande (CB$_5$) commande les premier et troisième interrupteurs par l'intermédiaire d'un optocoupleur (PH$_3$) dont le phototransistor est connecté d'une part, à l'entrée de commande de l'interrupteur à transistors (T$_{112}$, T$_{113}$) et d'autre part, la seconde borne du second condensateur (C$_{107}$).

13. Dispositif selon la revendication 9, caractérisé en ce que le deuxième interrupteur comprend un transistor MOS (T$_{114}$) dont la capacité grille-source détermine avec une résistance (R$_{131}$) en série avec sa grille une constante de temps fixant la durée pendant laquelle ledit transistor MOS est conducteur.

**Patentansprüche**

1. Leistungsschalteinrichtung (T$_{115}$, T$_5$) mit zumindest einer bipolaren Transistorleistungsstufe (T$_5$) und einem Steuerkreis für diese Stufe, wobei der Steuerkreis erste zur Erzeugung einer Vorspannung dienende Mittel, welche dazu dienen, die Stufe während erster Zeitintervalle (t$_3$) mit einer Vorspannung in direkter Richtung zu beaufschlagen, sowie zweite zur Erzeugung einer Vorspannung dienende Mittel besitzt, welche dazu dienen, die Stufe während zweiter Zeitintervalle (t$_2$, t$_4$) mit einer in inverser Richtung wirkenden Vorspannung zu beaufschlagen, die dazu bestimmt ist, zu verhindern, daß sich Ladungen in dem Transistor ansammeln, wenn dieser einer inversen Spannung ausgesetzt ist, dadurch gekennzeichnet,
   – daß die ersten zur Erzeugung einer Vorspannung dienenden Mittel einen ersten Kondensator (C$_{108}$) und einen ersten Kommutierungsschaltkreis (D$_{120}$), T$_{113}$) umfassen, um den ersten Kondensator mittels einer Gleichspannungsquelle (V$_p$) selektiv während erster Zeitintervalle zu laden und den ersten Kondensator in einen Steuereingang (T$_{115}$-G) dieser Stufe zu entladen und
   – daß die zweiten zur Erzeugung einer Vorspannung dienenden Mittel einen zweiten Kondensator (C$_{107}$) und einen zweiten Kommutierungsschaltkreis (D$_{119}$, D$_{123}$, T$_{113}$, T$_{114}$) umfassen, um den zweiten Kondensator mittels der Spannungsquelle während zweiter Zeitintervalle selektiv zu laden und den zweiten Kondensator in den Steuereingang zu entladen.

2. Leistungsschalteinrichtung nach Anspruch 1, dadurch gekennzeichnet,
   – daß der erste Kondensator (C$_{108}$) einen ersten Anschluß, welcher selektiv mit der Spannungsquelle (V$_p$) und mit dem Steuereingang (T$_{115}$-G) der Leistungsstufe verbindbar ist, sowie einen zweiten Anschluß besitzt, welcher mit einem Stromausgangsanschluß (E$_5$) der Leistungsstufe verbunden ist, und
   – daß der erste Kommutierungsschaltkreis ei-

nen ersten Schalter ($T_{113}$) zur Abtrennung des ersten Anschlusses des ersten Kondensators vom Steuereingang während der Ladephase des Kondensators und erste Sperrmittel ($D_{120}$) zur Abtrennung der Spannungsquelle ($V_p$) vom ersten Anschluß des Kondensators während zumindest der ersten Zeitintervalle ($t_3$) besitzt.

3. Leistungsschalteinrichtung nach Anspruch 2, dadurch gekennzeichnet,
   – daß der zweite Kondensator ($C_{107}$) einen ersten Anschluß, welcher selektiv mit der Spannungsquelle ($V_p$) und dem Stromausgangsanschluß ($E_5$) der Leistungsstufe verbindbar ist, und einen zweiten Anschluß besitzt, welcher selektiv mit dem Stromausgangsanschluß ($E_5$) und dem Steuereingang ($T_{115}$-G) der Leistungsstufe verbindbar ist,
   – daß der zweite Kommutierungsschaltkreis einen zweiten ($T_{114}$) und einen dritten ($T_{113}$) Schalter, um jeweils den ersten Anschluß des zweiten Kondensators vom Stromausgang der Leistungsstufe abzutrennen und den zweiten Anschluß des zweiten Kondensators während der Ladephase des zweiten Kondensators vom Steuereingang der genannten Leistungsstufe abzutrennen, sowie zweite ($D_{119}$) und dritte ($D_{123}$) Sperrmittel besitzt, um jeweils den ersten Anschluß des zweiten Kondensators von der Spannungsquelle abzutrennen und den zweiten Anschluß des zweiten Kondensators während der zweiten Zeitintervalle vom Stromausgang abzutrennen.

4. Leistungsschalteinrichtung nach Anspruch 3, dadurch gekennzeichnet,
   daß die ersten und dritten Schalter durch einen gleichen Transistorschalter ($T_{112}$, $T_{113}$) gebildet werden, bei dem ein Steuereingang durch ein Steuersignal ($CB_5$) gesteuert wird, der Kollektor einerseits mit dem ersten Anschluß des ersten Kondensators ($C_{108}$) über einen Widerstand ($R_{129}$) und andererseits mit dem Steuereingang ($T_{115}$-G) der Leistungsstufe verbunden ist und der Emitter an den zweiten Anschluß des zweiten Kondensators ($C_{107}$) angeschlossen ist.

5. Leistungsschalteinrichtung nach Anspruch 4, dadurch gekennzeichnet,
   daß der Transistorschalter ein Darlington-Transistor-Paar ($T_{112}$, $T_{113}$) aufweist.

6. Leistungsschalteinrichtung nach einem der Ansprüche 3 bis 5, dadurch gekennzeichnet,

daß die ersten und zweiten Sperrmittel gemeinsam eine erste Diode ($D_{149}$) aufweisen, welche zwischen der Spannungsquelle ($V_p$) und den jeweiligen ersten Anschlüssen der ersten und zweiten Kondensatoren ($C_{108}$, $C_{107}$) angeordnet ist.

7. Leistungsschalteinrichtung nach Anspruch 6, dadurch gekennzeichnet,
   daß die ersten und zweiten Sperrmittel außerdem jeweils zweite und dritte Dioden ($D_{120}$, $D_{119}$) umfassen, welche zwischen der ersten Diode ($D_{149}$) und den ersten Anschlüssen des ersten und zweiten Kondensators ($C_{108}$, $C_{107}$) angeordnet sind.

8. Leistungsschalteinrichtung nach einem der Ansprüche 6 und 7, wobei die Leistungsstufe ($T_{115}$, $T_5$) eine Hochpegelleitungsstufe eines Wechselrichters (20) ist, welche in Reihe mit einer Niederpegelleitungsstufe ($T_6$) zwischen einer Hochpegelleitung (31) und einer Niederpegelleitung (32) angeordnet ist, dadurch gekennzeichnet,
   daß die Spannungsquelle ($V_p$) an der Tiefpegelleitung (32) angeschlossen ist und daß die ersten und zweiten Sperrmittel ($D_{149}$, $D_{120}$, $D_{119}$) durch Wechsel des Vorzeichens der Potentialdifferenz ($V_p$-$V_m$) zwischen dem Eingangspunkt ($V_p$) der Spannungsquelle und dem Stromausgangsanschluß ($E_5$) der Hochpegelleitungsstufe gesteuert werden.

9. Leistungsschalteinrichtung nach Anspruch 8, dadurch gekennzeichnet,
   daß der zweite Schalter einen Transistor ($T_{114}$) aufweist, bei dem ein Steuereingang (G) einem vierten seinerseits von den Potentialdifferenzen gesteuerten Schalter ($T_{111}$) zugeordnet ist, ein Stromeingangsanschluß ($T_{114}$-D) mit dem ersten Anschluß des zweiten Kondensators ($C_{107}$) verbunden ist und ein Stromausgangsanschluß ($T_{114}$-S) mit dem Stromausgangsanschluß ($E_5$) der Leistungsstufe verbunden ist.

10. Leistungsschalteinrichtung nach Anspruch 9, dadurch gekennzeichnet,
    daß der vierte Schalter einen Transistor ($T_{111}$) aufweist, dessen Steuereingang mit dem Ausgang einer Teilerbrücke ($R_{125}$, $R_{132}$) verbunden ist, welche zwischen den Anschlüssen des ersten Kondensators ($C_{108}$) angeschlossen ist.

11. Leistungsschalteinrichtung nach einem der Ansprüche 8 bis 10, dadurch gekennzeichnet, daß die dritten Sperrmittel eine Diode ($D_{123}$) umfassen, welche zwischen dem zweiten Anschluß des zweiten Kondensators ($C_{107}$) und dem Stromausgang ($E_5$) der Leistungsstufe angeschlossen ist.

12. Leistungsschalteinrichtung nach Anspruch 4,

dadurch gekennzeichnet, daß das Steuersignal (CB$_5$) die ersten und dritten Schalter über einen Optokoppler (PH$_3$) steuert, dessen Phototransistor einerseits an den Steuereingang des Transistorschalters (T$_{112}$, T$_{113}$) und andererseits an den zweiten Anschluß des zweiten Kondensators (C$_{107}$) angeschlossen ist.

13. Leistungsschalteinrichtung nach Anspruch 9, dadurch gekennzeichnet, daß der zweite Schalter einen MOS-Transistor (T$_{114}$) aufweist, dessen Gitter-Source-Kapazität zusammen mit einem in Reihe mit seinem Gitter liegenden Widerstand (R$_{131}$) eine Zeitkonstante bestimmt, welche die Zeitdauer festlegt, während der der genannte MOS-Transistor leitend ist.


**Claims**

1/ A power switching circuit (T115, T5) including at least one bipolar transistor power stage (T5) and a control circuit for said stage, the control circuit including first bias means for applying forward bias to said stage during first time intervals (t3), and second bias means for applying reverse bias to said stage during second intervals (t2, t4), said reverse bias being intented to prevent charge accumulating in the transistor while it is subjected to a reverse voltage, the circuit being characterized in that:
the first bias means comprise a first capacitor (C108) and a first switching circuit (D120, T113) for selectively charging the first capacitor by means of a DC voltage source (Vp) outside the first time intervals, and for discharging the first capacitor into a control input (T115-G) of said stage; and
the second bias means comprise a second capacitor (C107) and a second switching circuit (D119, D123, T113, T114) for selectively charging the second capacitor from the voltage supply outside the second time intervals, and for discharging the second capacitor into the control input.

2/ A circuit according to claim 1, characterized in that:
the first capacitor (C108) has a first terminal selectively connectable to the voltage source (Vp) and to the control input (T115-G) of the power stage, and a second terminal connected to the current output terminal (R5) of the power stage; and
the first switching circuit comprising a first switch (T113) for isolating the first terminal of the first capacitor from the control input while the capacitor is charging, and a first blocking means (D120) for isolating the voltage source (Vp) from the first terminal of the capacitor at least during the first time intervals (t3).

3/ A circuit according to claim 2, characterized in that:

the second capacitor (C107) has a first terminal capable of being selectively connected to the voltage source (Vp) and to the current output terminal (E5) of the power stage, and a second terminal capable of being connected selectively to the current output terminal (R5) and to the control input (T115-G) of the power stage; and
the second switching circuit comprises second and third switches (T114, T113) serving respectively, while the second capacitor is charging, for isolating the first terminal of the second capacitor from the current output of the power stage, and for isolating the second terminal of the second capacitor from the control input of said stage, and second and third blocking means (D119, D123) serving respectively, during the second time intervals, for isolating the first terminal of the second capacitor from the voltage source, end for isolating the second terminal of the second capacitor from the current output.

4/ A circuit according to claim 3, characterized in that the first and third switches are constituted by the same transistor switch (T112, T113) having a control input under the control of a control signal (CB5), with its collector being connected firstly to the first terminal of the first capacitor (C108) via a resistor (R129) and secondly to the control input (T115-G) of the power stage, and with its emitter being connected to to the second terminal of the second capacitor (C107).

5/ A circuit according to claim 4, characterized in that the transistor switch comprises a Darlington transistor pair (T112, T113).

6/ A circuit according to any of claims 3 to 5 characterized in that the first and second blocking means comprise in common a first diode (D149) connected between the voltage source (Vp) and the respective first terminals of the first and second capacitor (C108, C107).

7/ A circuit according to claim 6, characterized in that the first and second blocking means also comprise respective second and third diode (D120, D119) connected between the first diode (D149) and the first terminals of the first and second capacitors (C108, C107).

8/ A circuit according to claim 6 or 7, in which the power stage (T115, T5) is a high rail stage of an inverter (20), connected in series with a low rail stage (T6) between a high rail conductor (31) and a low rail conductor (32), the circuit being characterized in that the voltage source (Vp) is referenced on low rail conductor (32) and in that the first and second blocking means (D149, D120, D119) are controlled by changes in the sign of the potential difference (Vp - Vm) between the input point (Vp) of the voltage source and the current output terminal (E5) of the high rail stage.

9/ A circuit according to claim 8, characterized in that the second switch comprises a transistor (T114) having a control input (G) associated with a fourth switch (T111) itself controlled by the change in potential, with a current input terminal thereof (T114-D) being connected to the first terminal of the second capacitor (C107) and with a current output terminal (T114-S) thereof being connected to the current output terminal (E5) of the power stage.

10/ A circuit according to claim 9, characterized in that the fourth switch comprises a transistor (T111) whose control input is connected to the output of a divider bridge (R125, R132) connected across the terminals of the first capacitor (C108).

11/ A circuit according to any one of claims 8 to 10, characterized in that the third blocking means comprise a diode (D123) connected between the second terminal of the second capacitor (C107) and the current output (E5) of the power stage.

12/ A circuit according to claim 4, characterized in that the control signal (CB5) controls the first and third switches via an optocoupler (PH3) whose phototransistor is connected firstly to the control input of the transistor switch (T112, T113) and secondly to the second terminal of the second capacitor (C107).

13/ A circuit according to claim 9, characterized in that the second switch comprises an MOS transistor (T114) whose gate-source capacitance together with a resistance (R131) connected in series with its gate determines a time constant which fixes the time during which said MOS transistor is conductive.

FIG. 1

FIG. 2

12

FIG. 3